# FASCICULE DE BREVET EUROPEEN

(11) **EP 2 436 241 B1**
(45) Date de publication et mention de la délivrance du brevet: **24.04.2013**
(21) Numéro de dépôt: 10734779.1
(22) Date de dépôt: 19.05.2010
(51) Int. Cl.: H05K 1/14, H05K 7/16, G09F 9/33, F21S 2/00, F21V 19/00, H01R 35/04

(54) **MODULE DE CIRCUITS IMPRIMES, MIS COTE A COTE ET ARTICULES ENTRE EUX, COMPORTANT DES COMPOSANTS ELECTRONIQUES ELECTROLUMINESCENTS**
NEBENEINANDER ANGEORDNETE UND MIT SCHARNIEREN VERBUNDENE LEITERPLATTENMODULE MIT ELEKTROLUMINESZENTEN ELEKTRONISCHEN BAUTEILEN
PRINTED CIRCUIT MODULES ARRANGED SIDE BY SIDE AND HINGED TOGETHER, COMPRISING ELECTROLUMINESCENT ELECTRONIC COMPONENTS

(30) Priorité: 26.05.2009 FR 0902544
(43) Date de publication de la demande: 04.04.2012
(73) Titulaire: KRS SA, 68126 Bennwihr Gare (FR)
(72) Inventeur: PETIT, Jacques, 67730 Chatenois (FR)
(74) Mandataire: Nuss, Laurent
(86) Numéro de dépôt international: PCT/FR2010/050974
(87) Numéro de publication internationale: WO 2010/136701

(56) Documents cités:
- JP-A- 9 171 874
- US-A- 4 173 035
- US-A- 4 701 133
- US-A- 4 715 819
- US-A- 5 241 451

## Description

La présente invention concerne le domaine de l'éclairage et a pour objet un module de circuits imprimés mis côte à côte et articulés entre eux, deux à deux, comportant des composants électroniques électroluminescents tels que des diodes électroluminescentes.

On sait que les diodes électroluminescentes, couramment abrégées sous le sigle DEL ou sous l'acronyme, tiré de l'anglais, LED (light-emitting diode), sont capables d'émettre de la lumière lorsqu'elles sont parcourues par un courant électrique. Elles sont généralement connectées à des circuits imprimés qui consistent chacun en une plaque rigide, neutre électriquement et généralement de forme carrée, rectangulaire ou ronde, comportant des pistes conductrices du courant électrique et des emplacements de connexion d'au moins une DEL, éventuellement recouverte d'un capot optique.

On connaît également des modules monoblocs constitués d'une pluralité d'ensembles d'au moins une DEL et dont chaque ensemble est généralement recouvert d'un capot optique. Cependant, un des problèmes fréquemment rencontré avec de tels modules monoblocs réside dans le fait que lorsque l'une desdites DEL d'un ensemble d'au moins une DEL ne fonctionne plus, celle-ci ne peut pas être réparée ou changée, ce qui oblige l'usager à jeter entièrement le module monobloc et à le remplacer par un autre.

Il a alors été trouvé comme solution à ce problème de segmenter les modules monoblocs grâce à des systèmes de couplage permuttant de connecter électriquement entre eux deux circuits imprimés adjacents comportant chacun au moins une DEL, de sorte que lorsqu'une ou plusieurs DEL d'un circuit imprimé dudit module ne fonctionnent plus, il suffit à l'usager de déconnecter le circuit imprimé concerné dudit module et de le remplacer par un nouveau.

De tels couplages électriques consistent généralement en des connecteurs ou des borniers qui sont soudés sur lesdits circuits imprimés et qui comprennent une partie mâle munie de broches de connexion et une partie femelle munie d'alvéoles destinées à recevoir lesdits broches, lesdites parties mâle et femelle étant soudées respectivement sur l'un des deux circuits imprimés à connecter entre eux.

On comprendra qu'avec ce type de système de connexion, l'enfichement des broches d'un bornier dans les alvéoles de l'autre bornier réalise simultanément et de façon indissociable la connexion électrique et mécanique des circuits imprimés entre eux.

Toutefois, si ce type de système de connexion assure une connexion électrique efficace entre deux circuits imprimés entre eux, les dimensions importantes des borniers génèrent un encombrement relativement important, notamment au niveau de l'interstice de liaison des deux circuits imprimés, qui ne permet pas de conserver un entraxe régulier entre les DEL d'un circuit imprimé à l'autre. D'autre part, les opérations de soudure nécessaires pour fixer ces systèmes de connexion renchérissent les coûts de fabrication.

En outre dans le cas de modules de circuits imprimés assemblés entre eux en formant une boucle, la fermeture de la boucle ne peut pas être effectuée au moyen des connecteurs ou des borniers précités. En effet, si ces derniers sont aptes à assurer une connexion mécanique desdits deux circuits imprimés fermant ladite boucle, ils assurent également leur mise en connexion électrique, ce qui a pour effet de créer un court circuit.

Enfin, les modules actuels ne permettent pas de réaliser un déplacement angulaire relatif des circuits imprimés entre eux en vue de régler leur inclinaison l'un par rapport à l'autre, ce afin de réaliser par exemple une boucle fermée de circuits imprimés munis de DEL sans détruire l'entre axe entre les DEL. En effet les modules actuels qui comportent des connecteurs ou des borniers aptes à assurer, de façon indissociable, la connexion mécanique et électrique ont pour effet de créer un court circuit du circuit électrique résultant de la boucle.

Le document US 4 715 819 A concerne un connecteur pour circuits imprimés comprenant des premier et second supports destinés à être fixés respectivement sur des premier et second circuits imprimés, le premier support comportant une pluralité de premiers contacts destinés à être connectés au premier circuit imprimé et le second support comprenant une pluralité de seconds contacts destinés à être connecté au second circuit imprimé. Les premier et second supports sont adaptés pour être ensemble montés pivotants autour d'un axe transversal de sorte à permettre l'articulation des premier et second circuits imprimés entre eux et leur connexion électrique via les premiers et seconds contacts. Ces derniers sont insérés dans une ou plusieurs rainures pratiquées dans les premiers ou seconds supports. Chaque premier contact présente une forme en L inversé avec la branche horizontale en forme de fourche et est apte à être connecté à un second contact présentant la forme d'une plaque avec un bord arrondi. Plus particulièrement, chaque premier contact en L est inséré par sa branche horizontal dans une rainure et sa branche verticale est engagée dans une autre rainure formée entre deux butées de maintien, tandis que chaque second contact est engagé dans une rainure s'étendant entre les deux axes. L'axe de pivotement est formé par deux axes situés aux extrémités latérales du second support destinés chacun à être engagé dans une gorge d'insertion du premier support. Un tel axe, à l'état monté, s'étend, avec l'ensemble du connecteur, entre les premier et second circuits imprimés qui peuvent alors pivoter l'un par rapport à l'autre depuis une position de pivotement où les deux circuits sont parallèles entre eux jusqu'à une position de pivotement où les deux circuits sont perpendiculaires entre eux. Dans une variante l'axe de pivotement s'étend en retrait de l'interstice des deux circuits imprimés et l'ensemble du connecteur s'étend en dehors dudit interstice et du plan de chaque circuit imprimé.

Toutefois, dans le connecteur objet de ce document, les premiers contacts présentent une forme très différente des seconds contacts, ce qui nécessite des modes de fixation différents dans leurs supports respectifs et qui sont rendus encore plus complexes pour ce qui concerne les seconds contacts en L qui doivent être engagés chacun dans deux rainures différentes. Un tel connecteur ne permet donc pas un montage aisé et rapide d'un faible coût. Par ailleurs, ce type de connecteur présente un encombrement important que ce soit dans la forme où celui-ci s'étend entre les circuits imprimés en les décalant perpendiculairement et notablement l'un de l'autre ou dans la forme où l'axe est décalé en retrait de l'interstice et où l'ensemble du connecteur est situé en dehors de ce dernier et du plan des circuits imprimés. D'autre part, un tel connecteur ne peut pas être plié dans les deux sens, c'est-à-dire de part et d'autre d'un plan contenant les deux circuits imprimés, vers l'intérieur ou vers l'extérieur. Enfin, le point de contact entre un premier et un second contact, qui est situé en retrait de l'axe de pivotement, c'est-à-dire en dehors de l'axe de pivotement, ne permet pas de réduire davantage l'écartement entre les circuits imprimés quelque soit l'angle de pivotement entre les circuits imprimés.

La présente invention a pour but de pallier ces inconvénients en proposant un module de circuits imprimés comportant des composants électroniques électroluminescents, tels que des DEL, permettant un déplacement angulaire relatif des circuits imprimés entre eux, tout en préservant un entre axe régulier entre les LED d'un circuit imprimé à l'autre et en offrant un encombrement réduit et une grande simplicité de montage avec un coût réduit ainsi qu'une modularité de connexion permettant la connexion mécanique et électrique des circuits imprimés deux à deux entre eux.

A cet effet, le module de circuits imprimés, selon la présente invention, comprend au moins deux circuits imprimés mis côte à côte et articulés entre eux, deux à deux, lesdits circuits imprimés présentant chacun sensiblement la forme d'une plaque, dont l'une ou l'autre des faces comporte notamment un ensemble d'au moins un composant électronique électroluminescent, tel qu'une DEL, et un réseau de pistes conductrices du courant électrique, lesdits circuits imprimés étant connectés entre eux, deux à deux, au moyen d'un dispositif de connexion constitué par au moins un support de connexion articulé constitué par deux parties de support de connexion articulées l'une à l'autre autour d'un axe de pivotement transversal s'étendant sensiblement le long de l'interstice de liaison, au niveau ou à proximité de ce dernier, des deux circuits imprimés concernés, ce de manière à permettre un déplacement angulaire desdits circuits imprimés, l'un par rapport à l'autre, autour dudit axe transversal, en vue de les incliner l'un par rapport à l'autre, chaque support de connexion articulé portant des moyens de fixation permettant de fixer, de manière amovible, ledit support de connexion articulé sur les deux circuits imprimés concernés pour assurer la liaison mécanique de ces derniers entre eux et au moins une structure de contact, au moins en partie conductrice du courant électrique, susceptible d'être fixée, de manière amovible, sur chaque support de connexion, ladite structure comportant deux surfaces de contact conductrices du courant électrique reliées entre elles par une partie de liaison conductrice du courant électrique et destinées chacune à être en contact avec une piste conductrice du courant électrique de l'un des deux circuits imprimés de manière à assurer la continuité électrique entre ces derniers.

Conformément à la présente invention un tel module se caractérise essentiellement en ce que chaque structure de contact comprend deux éléments de contact, au moins en partie conducteur du courant électrique, comportant chacun une première surface de contact conductrice du courant électrique destinée à être mise en contact avec l'une des pistes conductrices du courant électrique du circuit imprimé correspondant et une deuxième surface de contact conductrice du courant électrique, s'étendant sensiblement perpendiculairement à la première surface de contact et mise en contact avec ladite première surface de contact et en ce que, d'une part, lesdites deuxièmes surfaces de contacts forment ladite partie de liaison conductrice et, d'autre part, un évidement est pratiqué dans le côté de liaison de chaque circuit imprimé, chaque élément de contact comprenant, entre la première et la deuxième surface de contact, une ouverture destinée à recevoir un plot de fixation s'étendant de chaque support de connexion articulé à travers l'interstice de liaison et plus particulièrement à travers l'espace créé par les évidements de manière à pouvoir positionner et maintenir, de manière amovible, chaque élément de contact sur chaque support de connexion articulé.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :
- la figure 1 représente une vue en perspective éclatée, dans un mode de réalisation préférentiel, d'un module de circuits imprimés, selon la présente invention, comprenant deux circuits imprimés comportant chacun un ensemble d'au moins une DEL et susceptibles d'être assemblés et articulés l'un avec l'autre,
- la figure 2 représente une vue en perspective de trois quart d'un côté latéral et de dessous du module représenté sur la figure 1, dans une configuration des circuits imprimés assemblés et articulés entre eux,
- la figure 3 représente une vue en perspective de trois quart de dessus du module représenté sur la figure 2,
- la figure 4 représente une vue en perspective partielle de trois-quarts de dessus du module représenté sur la figure 2, dans une configuration où un seul des deux circuits imprimés est assemblé sur le support de connexion articulé,
- la figure 5 représente une vue en perspective de trois quart de dessous du côté latéral du module représenté sur la figure 4,
- la figure 6 représente une vue de dessus d'un support de connexion articulé d'un module selon la présente invention dans une variante des moyens de fixation dudit support sur deux circuits imprimés,
- la figure 7 représente une vue de face d'une extrémité de liaison du support de connexion articulé de la figure 6,
- la figure 8 représente une vue de profil d'un module, selon la présente invention, constitué de la connexion de plusieurs circuits imprimés rectangulaires ou carrés entre eux, susceptibles de recevoir chacun un ensemble d'au moins une DEL, et inclinés les uns par rapport aux autres selon une configuration en ondulation en dents de scie,
- la figure 9 représente une vue de dessus d'un module de circuits imprimés, selon la présente invention, constitué de la connexion entre eux de plusieurs circuits imprimés en forme de quart de cercle et de demi cercle comportant chacun un ensemble d'au moins une DEL, selon une configuration en boucle en forme de couronne circulaire plane,
- la figure 10 représente une vue de profil d'un module de circuits imprimés, selon la présente invention, constitué de la connexion entre eux de plusieurs circuits imprimés carrés ou rectangulaires comportant chacun un ensemble d'au moins une DEL et inclinés les uns par rapport aux autres selon une configuration en boucle en forme d'anneau,
- la figure 11 représente une vue de dessus d'un élément de contact d'un module de circuits imprimés selon la présente invention,
- la figure 12 représente une vue de côté de l'élément de contact de la figure 11,
- la figure 13 représente une vue en perspective de l'élément de contact de la figure 11,
- la figure 14 représente une vue en plan d'un support de connexion articulé avec deux parties de support articulées entre elles comprenant deux faces de fixation, chacune respectivement sur l'un des deux circuits imprimés à connecter entre eux, mises à l'envers l'une par rapport à l'autre,
- la figure 15 représente une vue de côté du support de connexion de la figure 14,
- la figure 16 représente une vue de dessus de deux circuits imprimés comportant une pluralité de DEL de tension avec un câblage en parallèle, connectés entre eux au moyen de deux supports de connexion articulés d'un module de circuits imprimés selon la présente invention,

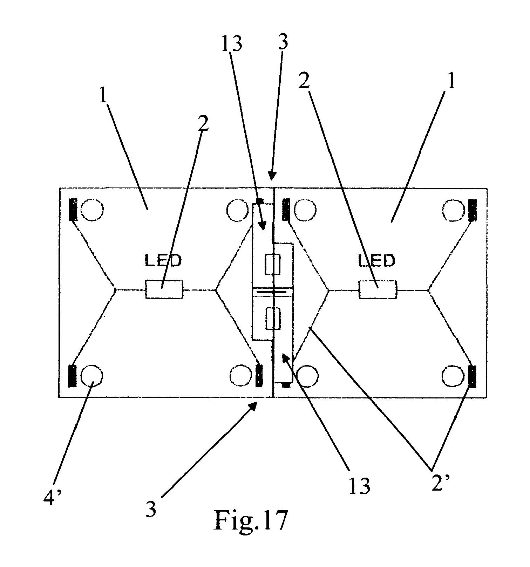

- la figure 17 représente une vue de dessus de deux circuits imprimés comportant chacun une DEL de puissance avec un câblage en parallèle, connectés entre eux au moyen de deux supports de connexion articulés d'un module de circuits imprimés selon la présente invention.

Les figures montrent un module de circuits imprimés 1 comprenant au moins deux circuits imprimés 1 mis côte à côte et articulés entre eux, deux à deux, lesdits circuits imprimés 1 présentant chacun sensiblement la forme d'une plaque, de préférence de forme, par exemple, carrée, rectangulaire, ronde, en quart de cercle, dont l'une ou l'autre des faces comporte notamment un ensemble d'au moins un composant électronique électroluminescent 2, tel qu'une DEL, et un réseau de pistes conductrices 2' du courant électrique.

Conformément à la présente invention, les circuits imprimés 1 d'un module selon la présente invention sont connectés entre eux, deux à deux, au moyen d'un dispositif de connexion constitué par au moins un support de connexion 3 articulé constitué par deux parties de support de connexion 7 articulées l'une à l'autre autour d'un axe de pivotement transversal 6 s'étendant sensiblement le long de l'interstice de liaison, au niveau ou à proximité de ce dernier, des deux circuits imprimés 1 concernés, ce de manière à permettre un déplacement angulaire desdits circuits imprimés 1, l'un par rapport à l'autre, autour dudit axe transversal 6, ce en vue de les incliner l'un par rapport à l'autre, chaque support de connexion 3 articulé portant, d'une part, des moyens de fixation 4 permettant de fixer, de manière amovible, ledit support de connexion 3 articulé sur lesdits circuits imprimés 1 concernés pour assurer la liaison mécanique de ces derniers entre eux et, d'autre part, des moyens de connexion électrique 12, 12', 13, 14 amovibles permettant d'assurer la continuité électrique entre lesdits circuits imprimés 1.

On notera qu'un ensemble d'au moins un composant électronique électroluminescent 2 et plus particulièrement une DEL peut de manière connue être recouvert d'un capot optique 2".

De préférence, les moyens de fixation, de manière amovible, du support de connexion 3 articulé aux circuits imprimés 1 peuvent être des moyens d'assemblage amovibles 4 par déformation élastique.

Chaque support de connexion 3 articulé peut alors être fixé sur l'une des deux faces opposées des deux circuits imprimés 1 concernés, de préférence le cas échéant sur la face ne comportant pas de composants électroniques électroluminescents 2, lesdits circuits imprimés 1 comportant des perçages 4' et les moyens d'assemblage amovibles 4 par déformation élastique pouvant consister en des éléments d'accrochage fixés sur ou traversant chaque support de connexion 3 articulé et susceptibles de venir s'encliqueter ou s'insérer, de façon amovible, par déformation élastique dans les perçages 4' correspondants desdits circuits imprimés 1, ce de manière à assurer une liaison mécanique verrouillée entre chaque support de connexion 3 articulé et lesdits circuits imprimés 1.

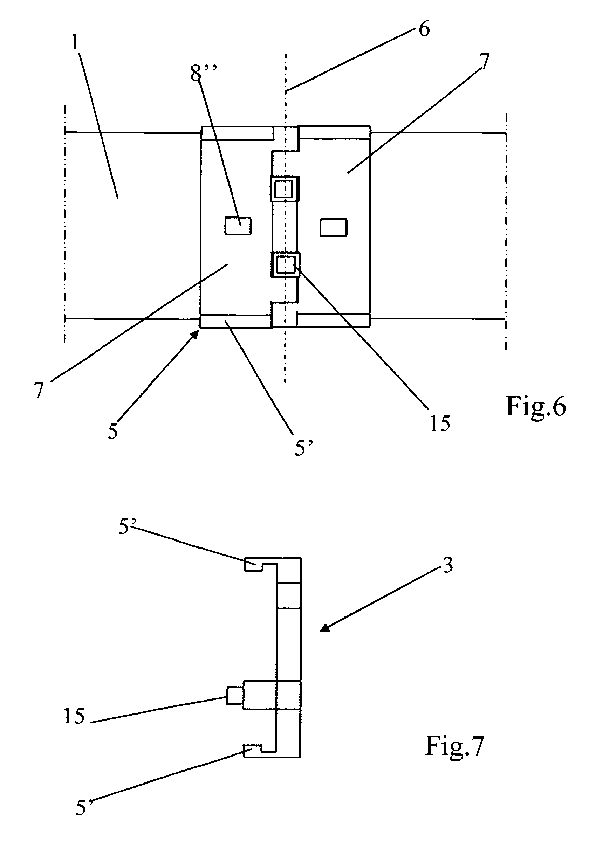

Dans une variante des moyens de fixation aux circuits imprimés 1 de chaque support de connexion 3 articulé, ceux-ci peuvent être des moyens d'assemblage amovibles par emboîtement par glissement 5 (figure 6).

De préférence, les moyens d'assemblage amovibles par emboîtement par glissement, comme on peut le voir sur la figure 6, consistent en deux extrémités de liaison 5 opposées du support de connexion 3 articulé aptes chacune à être reliée au côté de liaison de l'un des deux circuits imprimés 1. Chaque extrémité de liaison comporte des bords latéraux 5', profilés en forme de rainures, susceptibles de recevoir, par glissement dans lesdites rainures, les côtés latéraux 1' correspondants du circuit imprimé 1 considéré.

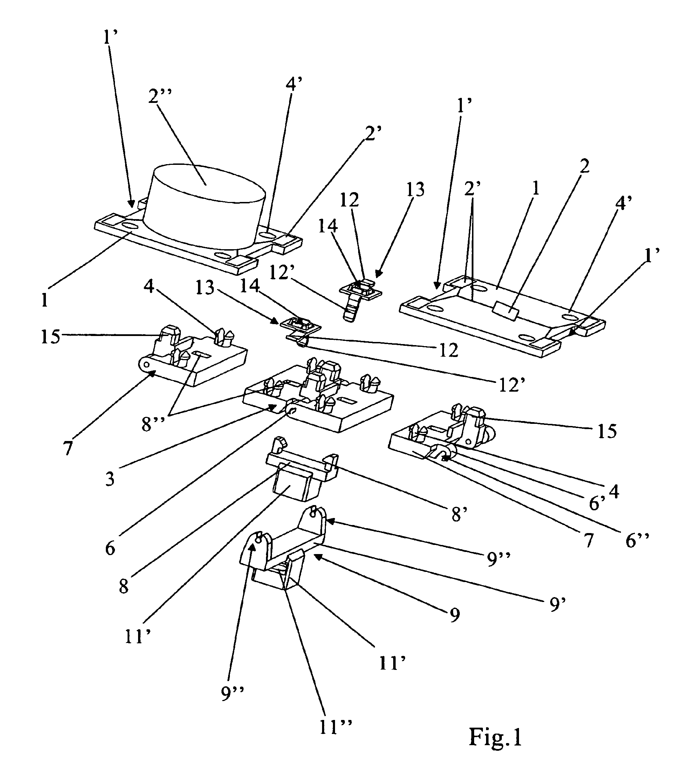

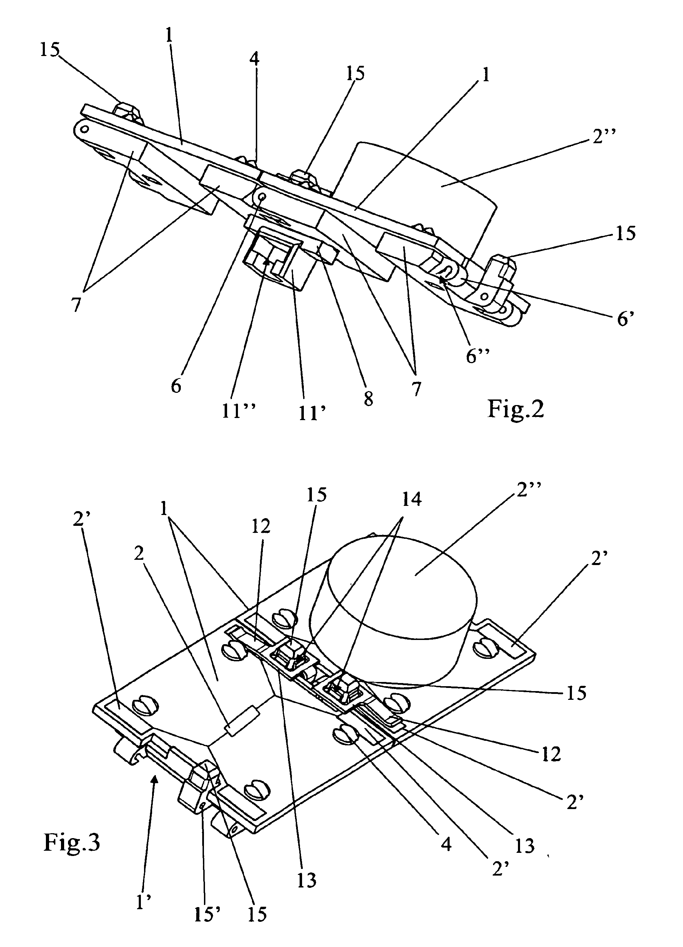

En outre, il peut être avantageusement prévu que chaque support de connexion 3 articulé, selon la présente invention, comporte des moyens de blocage des deux circuits imprimés 1 dans une position angulaire relative souhaitée qui peuvent consister, par exemple, soit en un étrier 8 susceptible de relier rigidement les deux parties de support 7 de manière à maintenir les deux circuits imprimés 1 sensiblement dans un même plan (figure 2), soit en une pièce d'appui 9 permettant de fixer le support de connexion 3 articulé sur une surface de support 10 par l'intermédiaire d'une embase 11, ladite pièce d'appui 9 étant montée en rotation libre sur l'axe de pivotement transversal 6 des deux parties de support 7 dudit support de connexion 3 (figure 1, figure 4 et figure 5).

L'étrier 8 peut, préférentiellement, comporter des plots d'encliquetage 8' destinés à être encliquetés dans des perçages 8" pratiqués dans le support de connexion 3 articulé.

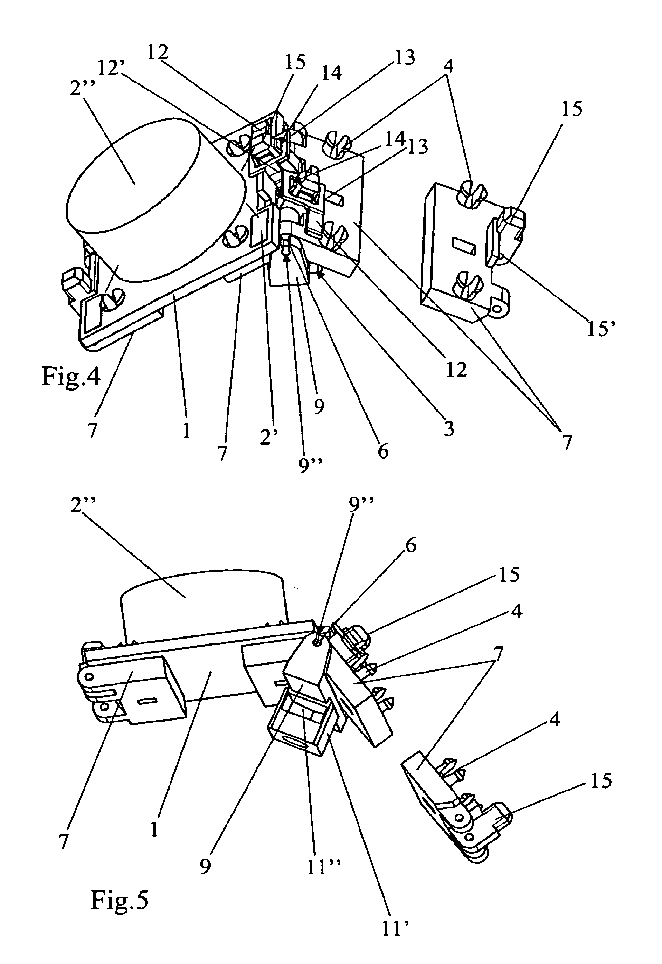

On peut voir plus particulièrement sur la figure 1 que la pièce d'appui 9 peut présenter, par exemple, une forme sensiblement de balancelle comprenant un siège 9' dont la face inférieure externe comporte sensiblement centralement une pièce intermédiaire 11' permettant d'assurer sa liaison avec l'embase 11. On peut voir également que le siège 9' est surmonté avantageusement au niveau de chacun de ses bords latéraux par un organe d'accrochage 9" susceptible d'être accroché, par exemple par encliquetage, à l'axe de pivotement transversal 6, de préférence de part et d'autre du support de connexion 3 articulé (figure 4 et figure 5).

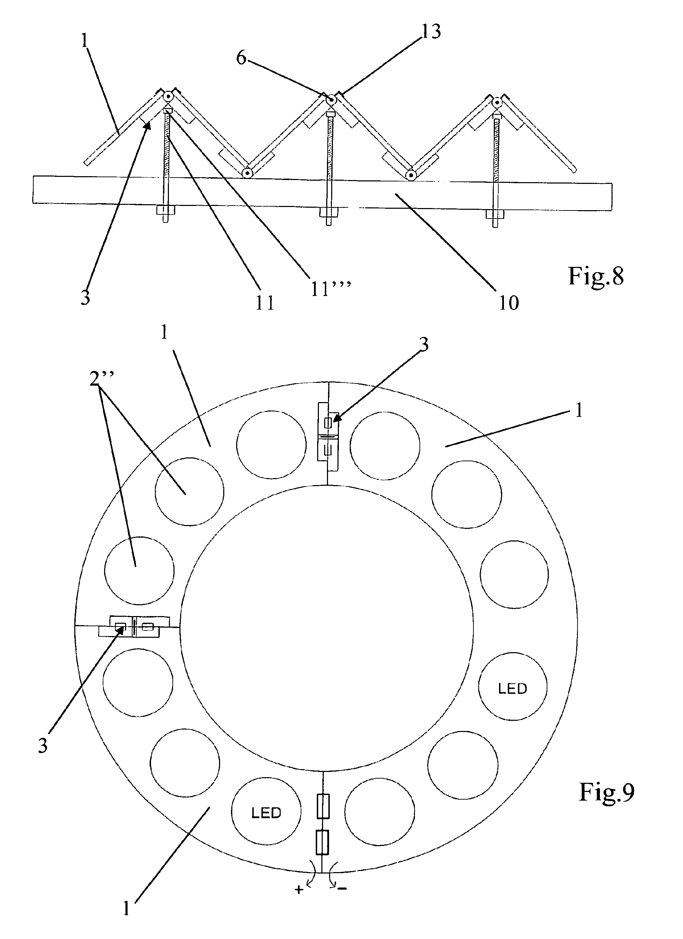

La pièce intermédiaire 11' peut en outre comporter un logement 11" apte à recevoir une partie de l'embase 11, laquelle embase 11 pouvant consister en un axe, par exemple une tige filetée, fixé sensiblement perpendiculairement à la surface de support 10 et se terminant à son extrémité libre par une tête d'accrochage, tel qu'un écrou 11"' (figure 8), destiné à être inséré dans le logement 11 " de ladite pièce intermédiaire 11' de manière à fixer cette dernière à ladite embase 11.

De même, l'étrier 8 peut comporter à sa partie inférieure une telle pièce intermédiaire 11' pour permettre sa fixation à une surface de support de 10.

De préférence, les moyens de connexion électrique amovibles peuvent consister en au moins une structure de contact 12, 12', 13, 14, au moins en partie conductrice du courant électrique, susceptible d'être fixée, préférentiellement, de manière amovible, sur chaque support de connexion 3 articulé et comportant deux surfaces de contact 12 conductrices du courant électrique reliées entre elles par une partie de liaison conductrice du courant électrique et destinées chacune à être en contact avec une piste conductrice 2' du courant électrique de l'un des deux circuits imprimés 1 de manière à assurer la continuité électrique entre les deux circuits imprimés 1.

Un évidement 1' peut être avantageusement pratiqué dans le côté de liaison de chaque circuit imprimé 1 et chaque structure de contact 12, 12', 13, 14 peut comprendre deux éléments de contact 13, au moins en partie conducteur du courant électrique, susceptibles d'assurer la continuité électrique entre les deux circuits imprimés 1, chaque élément de contact 13 comportant une première surface de contact 12 conductrice du courant électrique destinée à être mise en contact avec une piste conductrice 2' du courant électrique du circuit imprimé 1 correspondant et une deuxième surface de contact 12', conductrice du courant électrique, s'étendant sensiblement perpendiculairement à la première surface de contact 12 et mise en contact avec ladite première surface de contact 12, ceci de manière à assurer la continuité électrique entre les deux circuits imprimés 1 avec ou sans inclinaison entre eux.

De préférence, chaque deuxième surface de contact 12' d'un élément de contact 13 peut être apte, en vue d'assurer la continuité électrique entre les éléments de contact 13, à être mise directement en contact par frottement de glissement et pression élastique avec la deuxième surface de contact 12' de l'autre élément de contact 13 dans l'espace formé par les évidements 1' respectifs des deux circuits imprimés 1 concernés assemblés et articulés l'un à l'autre, lesdites deuxième surface de contact 12' pouvant s'étendre dans un plan sensiblement perpendiculaire à l'axe de pivotement 6, tandis que les premières surfaces de contact 12 peuvent s'étendre dans un plan sensiblement parallèlement à l'axe de pivotement 6.

On comprendra alors aisément que dans le cas d'une structure de contact 12, 12', 13, 14 constituée par l'association de deux éléments de contact 13, la partie de liaison conductrice du courant électrique précitée peut être formée essentiellement par l'ensemble des deuxième surfaces de contact 12' des deux éléments de contact respectifs 13, de préférence mises en contact directement l'une avec l'autre par frottement de glissement et pression élastique.

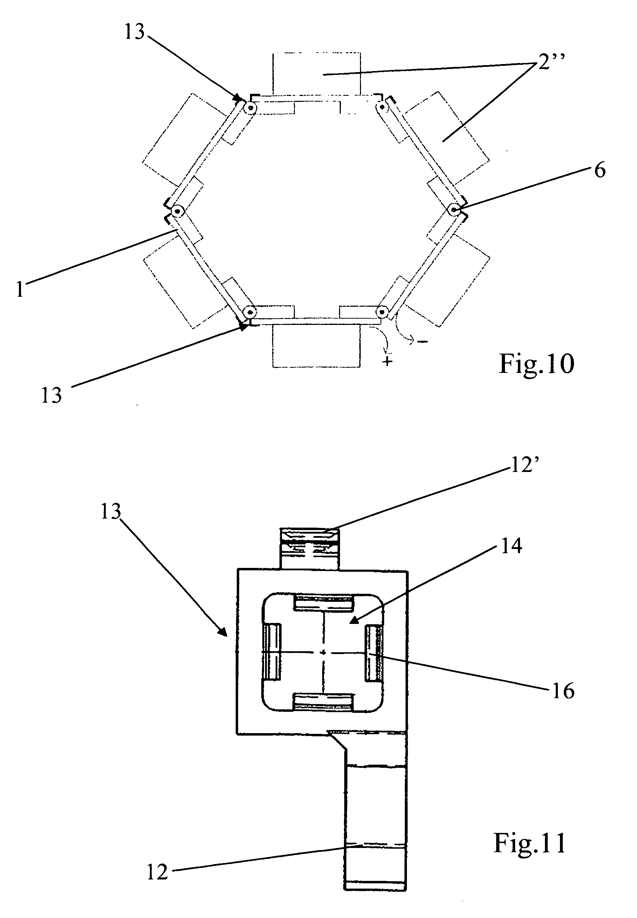

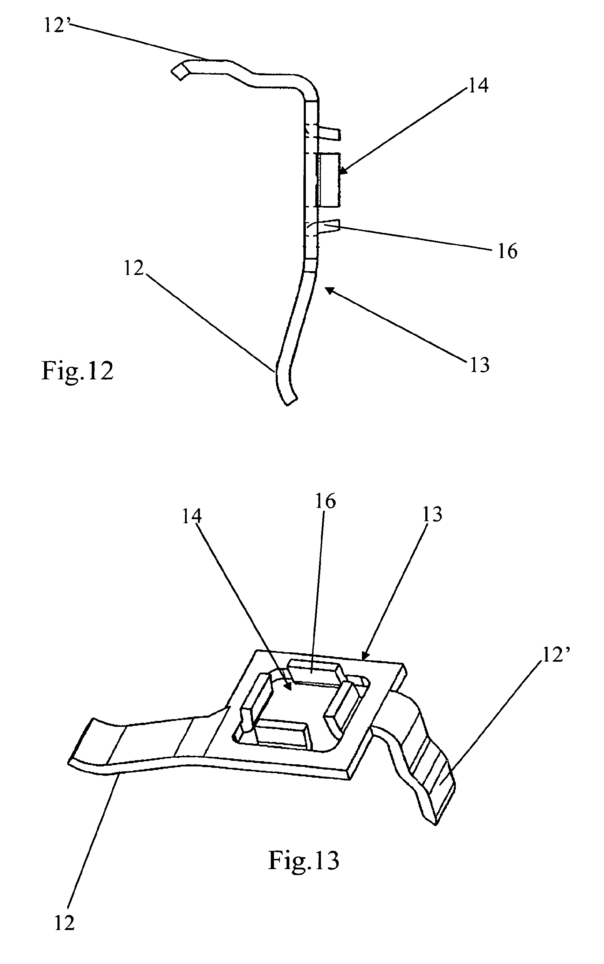

En outre, comme on peut le voir sur les figures 11 à 13, chaque élément de contact 13 peut avantageusement comprendre, entre la première 12 et la deuxième 12' surface de contact, une ouverture 14 destinée à recevoir un plot de fixation 15 (figures 1 à 5) s'étendant du support de connexion 3 articulé à travers l'interstice de liaison et plus particulièrement à travers l'espace créé par les évidements 1' de manière à pouvoir positionner et maintenir, de préférence de manière amovible, chaque élément de contact 13 sur chaque support de connexion 3 articulé. Dans ce cas, comme on peut le voir sur la figure 3, le plot de fixation 15 peut comporter un orifice 15' apte à recevoir un axe de pivotement 6, non représenté.

L'ouverture 14 d'un élément de contact 13 peut avantageusement comporter des éléments déformables élastiquement, tels que par exemple des ailettes 16 fixées sur la paroi interne de ladite ouverture 14, permettant d'introduire et de maintenir en place ledit plot dans ladite ouverture 14 (figures 11 à 13).

L'axe de pivotement 6 peut être de préférence discontinu, en étant constitué par exemple par deux parties d'axe de pivotement ou axes courts écarté(e)s axialement l'un(e) de l'autre, de sorte à laisser un passage libre à travers ledit axe de pivotement 6, par exemple entre lesdits axes courts, permettant aux deuxième surfaces de contact 12' des éléments de contact 13 de venir se loger dans les évidements 1' des circuits imprimés 1 articulés l'un à l'autre, de préférence en s'étendant sensiblement transversalement à l'axe de pivotement 6, par exemple entre les deux axes courts, permettant une continuité électrique dans un plan sensiblement transversal à l'axe de pivotement 6.

Dans ce dernier cas, une partie d'axe de pivotement de l'axe de pivotement 6, non représenté, peut être prévue pour traverser un premier émerillon 6' et le plot de fixation 15 situé à proximité de ce dernier, tandis que l'autre partie d'axe de pivotement peut être prévue pour traverser un deuxième émerillon 6' distant du plot de fixation 15 de manière à laisser le passage libre précité entre lesdites parties d'axe de pivotement et partant entre les deux plots de fixation 15 traversant les évidements 1' adjacents et situés chacun de préférence à proximité immédiate ou contre l'un des décrochements latéraux desdits évidements 1'.

Ainsi un tel positionnement et une telle étendue des première 12 et deuxième 12' surfaces de contact des éléments de contact 13 par rapport à l'axe de pivotement 6 permettent d'obtenir, d'une part, une surface de continuité électrique et une course de rotation, les plus petites possibles, d'autre part, que les deuxième surfaces de contact 12' soient de dimensions les plus petites possible, d'autre part encore, un écartement le plus court possible entre les circuits imprimés 1, et enfin un déplacement angulaire des circuits imprimés entre eux, deux à deux, dans un rayon de rotation le plus court possible et un déplacement angulaire relatif de chaque partie de support 7 entre elles d'un support de connexion 3 articulé.

Grâce à un module selon la présente invention, il est ainsi possible de réserver un emplacement pour positionner, dans le sens longitudinal, les DEL au plus près du bord des côtés de liaison des circuits imprimés 1 mis côte à côte, ce qui permet d'obtenir un entre axe le plus court possible entre les DEL montées sur lesdits circuits imprimés.

Par ailleurs, la présente invention peut prévoir que les deux parties de supports de connexion 7 soient aptes à être séparées l'une de l'autre grâce à des moyens d'accrochage amovibles 6" sur l'axe de pivotement 6 correspondant afin de permettre l'enlèvement dudit module d'un circuit imprimé 1, à réparer ou à changer, ensemble avec les parties de support de connexion (7) correspondantes fixées sur ledit circuit imprimé (1), notamment sur chacun de ses côtés de liaison, ce par simple décrochement desdites parties de support de connexion (7) des axes de pivotement (6) concernés.

Un moyen d'accrochage amovible 6" peut consister de préférence, comme on peut le voir sur les figures 1 à 3, en une encoche pratiquée dans des émerillon 6' permettant la rotation de chaque partie de support de connexion 7 autour de l'axe de pivotement 6, ce de manière à permettre un accrochage par encliquetage de ce dernier sur ledit axe de pivotement 6.

Dans le cas où l'axe de pivotement 6 comporte deux parties d'axe de pivotement, comme vu précédemment, pour laisser un passage libre à travers ledit axe de pivotement 6, seul l'émerillon 6' distant du plot de fixation 15 d'une partie de support de connexion 7 d'un support de connexion 3 est susceptible de comporter une encoche 6" pour son accrochage amovible sur la partie d'axe de pivotement traversant le plot de fixation 15 et l'émerillon 6' correspondant de l'autre partie de support de connexion 7 dudit support de connexion 3.

On comprendra donc que, selon la présente invention, l'enlèvement d'un circuit imprimé 1 d'un module peut se faire soit en enlevant ledit circuit imprimé 1 directement des parties de supports de connexion 7 correspondantes articulées chacune à une partie de support de connexion 7 fixée sur le circuit imprimé 1 adjacent audit circuit imprimé 1 à enlever, soit dans une variante en décrochant simplement les parties de support de connexion 7 fixées sur le circuit imprimé 1 à enlever des axes de pivotement 6 correspondants.

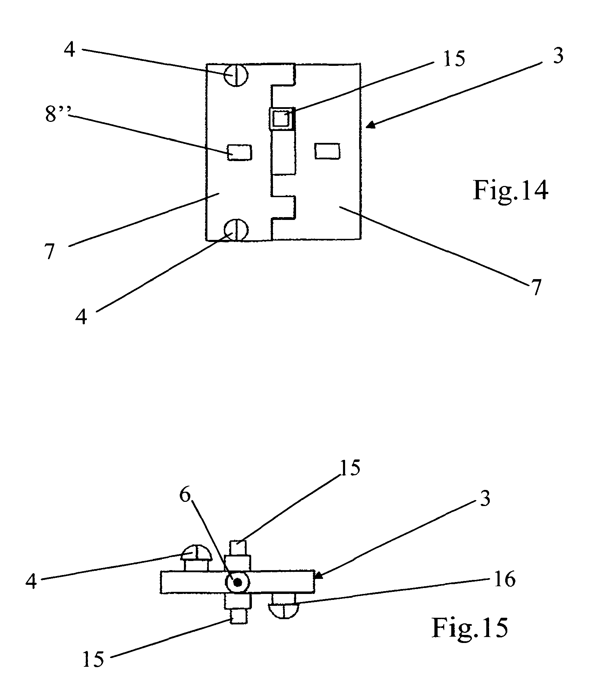

Si on se réfère aux figures 14 et 15 on peut voir qu'un support de connexion 3 articulé, selon la présente invention, réalisé en deux parties de support 7 articulées l'une à l'autre, peut comprendre deux faces de fixation dudit support 3, chacune respectivement sur l'un des deux circuits imprimés, non représentés, à connecter entre eux, mises à l'envers l'une par rapport à l'autre, ceci de manière à pouvoir connecter entre eux deux circuits imprimés dans une configuration retournés ou mis à l'envers l'un par rapport à l'autre relativement à leur face comportant un ensemble d'au moins une DEL.

Si on se réfère maintenant aux figures 8 à 10 on peut voir un module, dans des configurations diverses, comprenant au moins deux circuits imprimés 1 mis côte à côte entre eux, lesdits circuits imprimés 1 présentant chacun sensiblement la forme d'une plaque de forme, par exemple, carrée ou rectangulaire (figure 8 et figure 10, ou en quart de cercle ou demi cercle (figure 9), dont l'une ou l'autre des faces comporte notamment au moins un ensemble de composants électroniques capables d'émettre de la lumière, tels que des DEL 2, et un réseau de pistes conductrices, non représenté, du courant électrique. On peut voir également que les deux circuits imprimés 1 sont connectés entre eux au moyen du dispositif de connexion selon la présente invention.

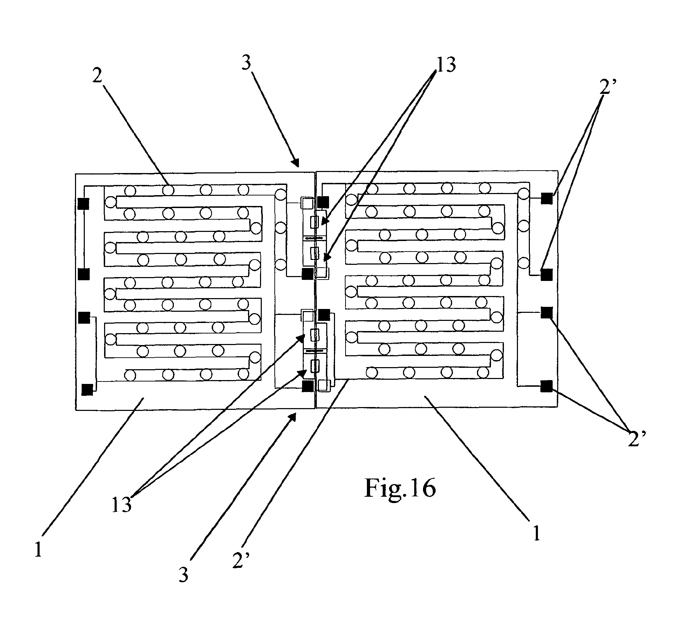

Enfin, si on se réfère à la figure 16, respectivement 17, on peut voir deux circuits imprimés 1 comportant chacun un ensemble d'au moins une DEL 2 de tension, respectivement un ensemble d'au moins une DEL 2 de puissance, avec un câblage en parallèle, connectés entre eux au moyen de deux supports de connexion 3 articulés d'un module selon la présente invention.

Si on se réfère plus particulièrement à la figure 9 et à la figure 10, on peut voir que l'un des dispositifs de connexion selon la présente invention, assurant la connexion entre le premier circuit imprimé 1 du module formant une boucle de circuits imprimés 1 et le dernier circuit imprimé 1 de ladite boucle, ne comporte pas d'éléments de contact 13 de manière à ne pas établir de connexion électrique entre une piste dudit premier circuit imprimé 1 et une piste dudit dernier circuit imprimé 1 de polarité (+) différente de celle (-) de la piste dudit premier circuit imprimé 1, ceci pour éviter un court circuit et assure donc uniquement la connexion mécanique entre lesdits premier et dernier circuit imprimés 1 de la boucle ainsi formée.

De préférence, un support de connexion 3 d'un module selon la présente invention peut être réalisé essentiellement à partir d'une matière isolante telle qu'une matière plastique ou à partir d'une matière servant aussi de dissipateur thermique comme la céramique. Par ailleurs, dans le cas d'une matière plastique, chaque support de connexion 3 peut comporter, de préférence, un dissipateur thermique rapporté tel que par exemple une plaque, comportant des ailettes de refroidissement, fixée sous chaque partie de support de connexion 7. La dissipation thermique est nécessaire dans le cas de DEL allant notamment au-delà de 350 mA.

Bien entendu, l'invention n'est pas limitée au mode de réalisation décrit et représenté aux dessins annexés. Des modifications restent possibles, notamment du point de vue de la constitution des divers éléments ou par substitution d'équivalents techniques, sans sortir pour autant du domaine de protection de l'invention.

## Revendications

1. Module de circuits imprimés (1) comprenant au moins deux circuits imprimés (1) mis côte à côte et articulés entre eux, deux à deux, lesdits circuits imprimés (1) présentant chacun sensiblement la forme d'une plaque, dont l'une ou l'autre des faces comporte notamment un ensemble d'au moins un composant électronique électroluminescent (2), tel qu'une DEL, et un réseau de pistes conductrices (2') du courant électrique, lesdits circuits imprimés (1) étant connectés entre eux, deux à deux, au moyen d'un dispositif de connexion constitué par au moins un support de connexion (3) articulé constitué par deux parties de support de connexion (7) articulées l'une à l'autre autour d'un axe de pivotement transversal (6) s'étendant sensiblement le long de l'interstice de liaison, au niveau ou à proximité de ce dernier, des deux circuits imprimés (1) concernés, ce de manière à permettre un déplacement angulaire desdits circuits imprimés (1), l'un par rapport à l'autre, autour dudit axe transversal (6), en vue de les incliner l'un par rapport à l'autre, chaque support de connexion (3) articulé portant des moyens de fixation (4) permettant de fixer, de manière amovible, ledit support de connexion (3) articulé sur les deux circuits imprimés (1) concernés pour assurer la liaison mécanique de ces derniers entre eux et au moins une structure de contact (12, 12', 13, 14), au moins en partie conductrice du courant électrique, susceptible d'être fixée, de manière amovible, sur chaque support de connexion (3), ladite structure comportant deux surfaces de contact (12) conductrices du courant électrique reliées entre elles par une partie de liaison conductrice du courant électrique et destinées chacune à être en contact avec une piste conductrice (2') du courant électrique de l'un des deux circuits imprimés de manière à assurer la continuité électrique entre ces derniers,
module **caractérisé en ce que** chaque structure de contact (12, 12', 13, 14) comprend deux éléments de contact (13), au moins en partie conducteur du courant électrique, comportant chacun une première surface de contact (12) conductrice du courant électrique destinée à être mise en contact avec l'une des pistes conductrices (2') du courant électrique du circuit imprimé (1) correspondant et une deuxième surface de contact (12') conductrice du courant électrique, s'étendant sensiblement perpendiculairement à la première surface de contact (12) et mise en contact avec ladite première surface de contact (12) et **en ce que**, d'une part, lesdites deuxièmes surfaces de contacts forment ladite partie de liaison conductrice et, d'autre part, un évidement (1') est pratiqué dans le côté de liaison de chaque circuit imprimé (1), chaque élément de contact (13) comprenant, entre la première (12) et la deuxième (12') surface de contact, une ouverture (14) destinée à recevoir un plot de fixation (15) s'étendant de chaque support de connexion (3) articulé à travers l'interstice de liaison et plus particulièrement à travers l'espace créé par les évidements (1') de manière à pouvoir positionner et maintenir, de manière amovible, chaque élément de contact (13) sur chaque support de connexion (3) articulé.

2. Module, selon la revendication 1, **caractérisé en ce que** les deuxième surfaces de contact (12') formant la partie de liaison conductrice sont mises en contact directement l'une avec l'autre par frottement de glissement et pression élastique.

3. Module, selon la revendication 2, **caractérisé en ce que** chaque deuxième surface de contact (12') d'un élément de contact (13) est apte, en vue d'assurer la continuité électrique entre les éléments de contact (13) à être mise en contact avec la deuxième surface de contact dans l'espace formé par les évidements (1') respectifs des deux circuits imprimés (1) concernés assemblés et articulés l'un à l'autre, lesdites deuxième surface de contact (12') s'étendant dans un plan sensiblement perpendiculaire à l'axe de pivotement (6), tandis que les premières surfaces de contact (12) s'étendent dans un plan sensiblement parallèle à l'axe de pivotement (6).

4. Module, selon l'une quelconque des revendications 1 à 2, **caractérisé en ce que** l'axe de pivotement (6) est discontinu, en étant constitué par deux parties d'axe de pivotement écartées axialement l'une de l'autre, de sorte à laisser un passage libre à travers ledit axe de pivotement (6) permettant aux deuxièmes surfaces de contact (12') des éléments de contact (13) de venir se loger dans les évidements (1') des circuits imprimés (1) articulés l'un à l'autre, en s'étendant sensiblement transversalement à l'axe de pivotement, entre les deux parties d'axe de pivotement, permettant une continuité électrique dans un plan sensiblement transversal à l'axe de pivotement.

5. Module, selon l'une quelconque des revendications 1 à 4, **caractérisé en ce que** les deux parties de supports de connexion (7) sont aptes à être séparées l'une de l'autre grâce à des moyens d'accrochage amovibles (6") sur l'axe de pivotement (6) correspondant afin de permettre l'enlèvement dudit module d'un circuit imprimé (1), à réparer ou à changer, ensemble avec les parties de support de connexion (7) correspondantes fixées sur ledit circuit imprimé (1), notamment sur chacun de ses côtés de liaison, ce par simple décrochement desdites parties de support de connexion (7) des axes de pivotement (6) concernés.

6. Module, selon l'une quelconque des revendications 1 à 5, **caractérisé en ce qu'**il comporte des moyens de blocage (8, 9, 10, 11) des deux circuits imprimés (1) dans une position angulaire relative souhaitée.

7. Module, selon l'une quelconque des revendications 1 à 6, **caractérisé en ce que** les moyens de fixation aux circuits imprimés (1) de chaque support de connexion (3) articulé sont des moyens d'assemblage amovibles par déformation élastique (4).

8. Module, selon la revendication 7, **caractérisé en ce que** chaque support de connexion (3) articulé est fixé sur l'une des deux faces opposées des deux circuits imprimés (1) concernés, de préférence le cas échéant sur la face ne comportant pas de composants électroniques, les deux circuits imprimés (1) comportant des perçages (4') et **en ce que** les moyens d'assemblage amovibles par déformation élastique consistent en des éléments d'accrochage (4), fixés sur ou traversant chaque support de connexion (3) articulé, susceptibles de venir s'encliqueter ou s'insérer de façon amovible par déformation élastique dans les perçages (4') correspondants desdits circuits imprimés (1) de manière à assurer une liaison mécanique verrouillée entre chaque support de connexion (3) articulé et les deux circuits imprimés (1).

9. Module, selon l'une quelconque des revendications 1 à 8, **caractérisé en ce que** chaque support de connexion (3) articulé comprend deux faces de fixation dudit support (3), chacune respectivement sur l'un des deux circuits imprimés (1) à connecter entre eux, mises à l'envers l'une par rapport à l'autre de manière à pouvoir connecter entre eux lesdits circuits imprimés (1) dans une configuration retournés ou mis à l'envers l'un par rapport à l'autre, relativement à leur face comportant un ensemble d'au moins une DEL (2).

## Claims

1. Printed circuit module (1) comprising at least two printed circuits (1) arranged side by side and hinged together, in pairs, each of said printed circuits (1) having substantially the form of a plate, where one or other of the surfaces comprises an assembly of at least one electroluminescent electronic component (2), such as an LED, and a network of electric current conducting tracks (2'), said printed circuits (1) being connected together, in pairs, using a connection device that consists of at least one hinged connection bracket (3) that comprises two connection bracket portions (7) hinged together about a transverse pivot axis (6) extending substantially along the linking gap, i.e. at or near the latter, of the two printed circuits (1) in question in order to enable an angular movement of said printed circuits (1) relative to each other about said transverse axis (6) so as to incline them relative to each other, each hinged connection bracket (3) having securing means (4) making it possible to fix in a removable manner said hinged connection bracket (3) to the two printed circuits (1) concerned to ensure the mechanical connection of the latter with one another and at least one contact structure (12, 12', 13, 14), at least in part a conductor of electric current, able to be fixed, in a removable manner, to each connection bracket (3), said structure comprising two contact surfaces (12) for conducting electric current connected together by an electric current conducting connection part and each intended to be in contact with an electric current conducting track (2') of one of the two printed circuits in such a way as to ensure electrical continuity between the latter,
said module being **characterised in that** each contact structure (12, 12', 13, 14) comprises two contact elements (13), at least in part a conductor of electric current, each comprising a first electric current conducting contact surface (12) intended to be put in contact with one of the conducting tracks (2') of electric current of the corresponding printed circuit (1) and a second electric current conducing contact surface (12') extending substantially perpendicular to the first contact surface (12) and put in contact with said first contact surface (12) and **in that**, on the one hand, said second contact surfaces form said conducting connecting part and, on the other hand, a recess (1') is formed in the connecting side of each printed circuit (1), each contact element (13) comprising, between the first (12) and the second (12') contact surface, an opening (14) intended to receive a securing pin (15) extending from each connection bracket (3) hinged across the linking gap and more particularly across the space created by the recesses (1') so as to be able to position and hold, in a removable manner, each contact element (13) on each hinged connection bracket (3).

2. Module, according to claim 1, **characterised in that** the second contact surfaces (12') forming the conducting connecting part are put in direct contact with one another by sliding friction and elastic pressure.

3. Module according to claim 2, **characterised in that** each second contact surface (12') of a contact element (13) is able, in order to ensure electric continuity between the contact elements (13), to be put in contact with the second contact surface in the space formed by the respective recesses (1') of the two printed circuits (1) in question that are assembled and hinged relative to one another, said second contact surface (12') extending in a plane substantially perpendicular to the pivot axis (6), whereas the first contact surfaces (12) extend in a plane substantially parallel to the pivot axis (6).

4. Module according to any one of claims 1 to 2, **characterised in that** the pivot axis (6) is discontinuous, being formed by two parts of the pivot axis spaced apart axially from one another, so as to leave a free passage across which said pivot axis (6) allowing to second contact surfaces (12') of contact elements (13) to be housed in the recesses (1') of the hinged together printed circuits (1) by extending substantially transversely to the pivot axis between the two parts of the pivot axis, allowing electrical continuity in a plane substantially transverse to the pivot axis.

5. Module according to any one of claims I to 4, **characterised in that** the two parts of connection brackets (7) are able to be separated from one another by means of detachable hooking means (6") on the corresponding pivot axis (6) in order to allow the removal of said module from a printed circuit (I), for repair or replacement, together with the corresponding parts of the connection bracket (7) fixed to said printed circuit (1), in particular on each of its connecting sides, by the simple unhooking of said parts of the connection bracket (7) from the pivot axes (6) concerned.

6. Module according to any one of claims 1 to 5, **characterised in that** it comprises means (8, 9, 10, 11) for locking the two printed circuits (1) in a desired relative angular position.

7. Module according to any one of claims 1 to 6, **characterised in that** the means for securing to the printed circuits (1) of each hinged connection of bracket (3) are assembly means that are removable by elastic deformation (4).

8. Module according to claim 7, **characterised in that** each hinged connection bracket (3) is fixed onto one of the two opposite surfaces of the two printed circuits (1) concerned, preferably if need be to the surface not comprising electronic components, the two printed circuits (1) comprising openings (4') and **in that** the assembly means that is removable by elastic deformation consists of hooking elements (4) fixed onto or traversing each hinged connection bracket (3), able to be clicked or inserted in a removable manner by elastic deformation into the corresponding openings (4') of said printed circuits (1) in order to ensure a looked mechanical connection between each hinged connection bracket (3) and the two printed circuits (1).

9. Module according to any one of claims 1 to 8, **characterised in that** each hinged connection bracket (3) comprises two fixing surfaces of said support (3), each respectively onto one of the two printed circuits (1) to be connected together, placed in reverse in relation to one another so as to connect between them said printed circuits (1) in an inverted configuration or positioned in reverse relative to one another in relation to their surface comprising an assembly of at least one LED (2).

## Patentansprüche

1. Leiterplattenmodul (1), umfassend mindestens zwei aneinanderstoßende und paarweise gelenkig miteinander verbundene Leiterplatten (1), wobei jede der genannten Leiterplatten (1) im Wesentlichen die Form einer Platte hat, deren eine oder andere Seite insbesondere eine Anordnung aus mindestens einem elektroluminiszenten elektronischen Bauteil (2), wie etwa einer LED, und einem Netzwerk von elektrisch leitenden Bahnen (2') aufweist, wobei die genannten Leiterplatten (1) paarweise mit Hilfe einer Verbindungsvorrichtung miteinander verbunden sind, die aus mindestens einem gelenkigen Verbindungsträger (3), bestehend aus zwei Verbindungsträgerteilen (7) gebildet ist, die um eine Querkippachse (6) gelenkig miteinander verbunden sind, die sich im Wesentlichen längs der Verbindungslücke, in deren Höhe oder Nähe, zwischen den beiden betroffenen Leiterplatten (1) erstreckt, derart, dass eine Winkelbewegung der genannten Leiterplatten (1) relativ zueinander um die genannte Querachse (6) ermöglicht wird, um sie relativ zueinander zu neigen, wobei jeder gelenkige Verbindungsträger (3) Befestigungsmittel (4) trägt, die erlauben, den genannten gelenkigen Verbindungsträger (3) abnehmbar an den beiden betroffenen Leiterplatten (1) zu befestigen, um die mechanische Verbindung der letzteren untereinander sicherzustellen, und mindestens eine Kontaktstruktur (12, 12', 13, 14), die mindestens teilweise elektrisch leitend und geeignet ist, abnehmbar an jedem Verbindungsträger (3) befestigt zu werden, wobei die genannte Einheit zwei elektrisch leitende Kontaktflächen (12) aufweist, die durch einen elektrisch leitenden Verbindungsbereich miteinander verbunden sind und die jeweils dazu bestimmt sind, mit einer elektrisch leitenden Leiterbahn (2') einer der beiden Leiterplatten in Kontakt zu stehen, um die elektrische Verbindung zwischen den letzteren sicherzustellen,
Modul, **dadurch gekennzeichnet, dass** jede Kontaktstruktur (12, 12', 13, 14) zwei Kontaktteile (13) umfasst, die mindestens teilweise elektrisch leitend sind, die jeweils eine erste elektrisch leitende Kontaktfläche (12) aufweisen, die dazu bestimmt ist, mit einer der elektrisch leitenden Leiterbahnen (2') der entsprechenden Leiterplatte (1) in Kontakt gebracht zu werden, und eine zweite elektrisch leitende Kontaktfläche (12'), die sich im Wesentlichen senkrecht zur ersten Kontaktfläche (12) erstreckt und mit der genannten ersten Kontaktfläche (12) in Kontakt steht, und dadurch, dass einerseits die genannten zweiten Kontaktflächen den genannten elektrisch leitenden Verbindungsbereich bilden und andererseits eine Ausnehmung (1') in der Verbindungsseite jeder Leiterplatte (1) ausgebildet ist, wobei jedes Kontaktteil (13) zwischen der ersten (12) und der zweiten (12') Kontaktfläche eine Öffnung (14) aufweist, die dazu dient, einen Befestigungsstift (15) aufzunehmen, der sich von jedem gelenkigen Verbindungsträger (3) durch die Verbindungslücke und insbesondere durch den Raum, der durch die Ausnehmungen (1') geschaffen wird, erstreckt, derart, dass jedes Kontaktteil (13) auf jedem gelenkigen Verbindungsträger (3) positioniert und abnehmbar gehalten werden kann.

2. Modul nach Patentanspruch 1, **dadurch gekennzeichnet, dass** die zweiten Kontaktflächen (12'), die den elektrischen leitenden Verbindungsbereich bilden, direkt durch Gleitreibung und elastischen Druck miteinander in Kontakt stehen.

3. Modul nach Patentanspruch 2, **dadurch gekennzeichnet, dass** jede zweite Kontaktfläche (12') eines Kontaktteils (13) geeignet ist, zur Sicherstellung der elektrischen Verbindung zwischen den Kontaktteilen (13) mit der zweiten Kontaktfläche in dem Raum in Kontakt gebracht zu werden, der durch die entsprechenden Ausnehmungen (1') der beiden betroffenen, zusammengesetzten und gelenkig miteinander verbundenen Leiterplatten (1) gebildet wird, wobei die genannten zweiten Kontaktflächen (12') in einer Ebene liegen, die auf der Kippachse (6) im Wesentlichen senkrecht steht, während die ersten Kontaktflächen (12) in einer Ebene liegen, die zur Kippachse (6) im Wesentlichen parallel ist.

4. Modul nach irgendeinem der Patentansprüche 1 bis 2, **dadurch gekennzeichnet, dass** die Kippachse (6) unterbrochen ist und aus zwei Kippachsenteilen besteht, die in Achsrichtung voneinander beabstandet sind, derart dass sie einen freien Durchgang durch die genannte Kippachse (6) lassen, der den zweiten Kontaktflächen (12') der Kontaktteile (13) erlaubt, sich in die Ausnehmungen (1') der miteinander gelenkig verbundenen Leiterplatten (1) einzufügen, wobei sie sich zwischen den beiden Kippachsenteilen im Wesentlichen quer zur Kippachse erstrecken und eine elektrische Verbindung in einer im Wesentlichen quer zur Kippachse liegenden Ebene erlauben.

5. Modul nach irgendeinem der Patentansprüche 1 bis 4, **dadurch gekennzeichnet, dass** die beiden Verbindungsträgerteile (7) dank entsprechender abnehmbarer Montagemittel (6") an der entsprechenden Kippachse (6) voneinander getrennt werden können, um das Abnehmen des genannten Moduls (1) von einer Leiterplatte zu Reparatur oder Ersatz gemeinsam mit den entsprechenden Verbindungsträgerteilen (7), die an der genannten Leiterplatte (1) befestigt sind, zu erlauben, und zwar auf jeder seiner Verbindungsseiten, durch einfaches Abmontieren der genannten Verbindungsträgerteile (7) von den betroffenen Kippachsen (6).

6. Modul nach irgendeinem der Patentansprüche 1 bis 5, **dadurch gekennzeichnet, dass** es Mittel zum Blockieren (8, 9, 10, 11) der beiden Leiterplatten (1) in einer gewünschten Winkelstellung zueinander aufweist.

7. Modul nach irgendeinem der Patentansprüche 1 bis 6, **dadurch gekennzeichnet, dass** die Mittel zur Befestigung jedes gelenkigen Verbindungsträgers (3) an den Leiterplatten (1) durch elastische Verformung abnehmbare Montagemittel (4) sind.

8. Modul nach Patentanspruch 7, **dadurch gekennzeichnet, dass** jeder gelenkige Verbindungsträger (3) auf einer der beiden gegenüberliegenden Seiten der beiden betroffenen Leiterplatten (1) befestigt ist, gegebenenfalls vorzugsweise auf der Seite, die keine elektronischen Bauteile trägt, wobei die beiden Leiterplatten (1) Bohrungen (4') aufweisen, und dadurch, dass die durch elastische Verformung abnehmbaren Montagemitel (4) aus Montageelementen (4) bestehen, die an jedem gelenkigen Verbindungsträger (3) befestigt sind oder ihn durchdringen und geeignet sind, durch elastische Verformung in die entsprechenden Bohrungen (4') der genannten Leiterplatten (1) abnehmbar einzuschnappen oder sich einzufügen, um eine blockierte, mechanische Verbindung zwischen jedem gelenkigen Verbindungsträger (3) und den beiden Leiterplatten (1) sicherzustellen.

9. Modul nach irgendeinem der Patentansprüche 1 bis 8, **dadurch gekennzeichnet, dass** jeder gelenkige Verbindungsträger (3) zwei Seiten zur Befestigung des genannten Trägers (3) aufweist, je eine zur Befestigung an einer der beiden miteinander zu verbindenden Leiterplatten (1), die eine relativ zur anderen umgedreht, um die genannten Leiterplatten (1) in einer umgedrehten Anordnung oder relativ zueinander umgekehrt verbinden zu können, in Bezug auf ihre eine Einheit aus mindestens einer LED (2) tragende Seite.
